# FASCICULE DE BREVET EUROPEEN

(11) **EP 2 234 115 B1**
(45) Date de publication et mention de la délivrance du brevet: **19.12.2012**
(21) Numéro de dépôt: 10157354.1
(22) Date de dépôt: 23.03.2010
(51) Int. Cl.: G11C 16/04, H01L 29/423, H01L 21/28, H01L 29/788, B82Y 10/00, H01L 29/66

(54) **Procédé de réalisation d'un dispositif mémoire à nanoparticules conductrices**
Verfahren zur Herstellung einer Speichervorrichtung mit leitenden Nanoteilchen
Method for manufacturing a memory device with conductive nanoparticles

(30) Priorité: 27.03.2009 FR 0901463
(43) Date de publication de la demande: 29.09.2010
(73) Titulaire: Commissariat à l'Énergie Atomique et aux Énergies Alternatives, 75015 Paris (FR); Centre National de la Recherche Scientifique, 75016 Paris (FR)
(72) Inventeur: Deleonibus, Simon, 38640 Claix (FR); Basset, Jean-Marie, 69300 Caluire-et-Cuire (FR); Campbell, Paul, 69007 Lyon (FR); Gutel, Thibaut, 45120 Cepoy (FR); Haumesser, Paul-Henri, 38500 Saint Cassien (FR); Marchand, Gilles, 38119 Pierre-Chatel (FR); Santini, Catherine, 69660 Collonges au Mont d'Or (FR)
(74) Mandataire: Ilgart, Jean-Christophe

(56) Documents cités:
- US-A1- 2009 074 950

## Description

### DOMAINE TECHNIQUE

L'invention se rapporte au domaine des mémoires électroniques et à la réalisation de telles mémoires. L'invention concerne plus particulièrement la réalisation d'un dispositif électronique ou microélectronique de mémorisation, ou dispositif mémoire, de type non-volatile, c'est-à-dire conservant les données en l'absence d'alimentation électrique, à nanoparticules électriquement conductrices, par exemple de type Flash.

### ÉTAT DE LA TECHNIQUE ANTÉRIEURE

On cherche généralement à réaliser des mémoires ou des circuits de mémoire avec des capacités de stockage d'informations et des vitesses d'écriture et de lecture toujours plus importantes. Ces objectifs impliquent de miniaturiser les composants électroniques formant ces mémoires et d'augmenter les densités d'intégration de ces composants.

Un dispositif mémoire classique à grille flottante, c'est-à-dire un composant électronique individuel de mémorisation, a une structure proche de celle d'un transistor à effet de champ, c'est-à-dire comporte une source, un canal et un drain. Toutefois, par rapport à un transistor à effet de champ qui ne comporte qu'une seule grille de commande disposée au-dessus du canal, le dispositif mémoire comporte une structure de grilles comprenant une grille flottante et une grille de commande, ces deux grilles étant isolées électriquement l'une de l'autre par une couche inter-grilles à base d'un matériau diélectrique et disposée entre ces deux grilles. L'état dans lequel se trouve la grille flottante (en fonction du nombre d'électrons stockés dans la grille flottante) représente la valeur du bit mémorisé par le dispositif mémoire.

Un tel dispositif mémoire à grille flottante présente plusieurs inconvénients lorsque l'on cherche à le miniaturiser. En effet, la réduction des dimensions de ce dispositif implique nécessairement de réduire l'épaisseur du diélectrique qui isole la grille flottante du substrat. Cette réduction d'épaisseur de ce diélectrique entraîne des problèmes de rétention de l'information par le dispositif mémoire car les électrons stockés dans la grille flottante peuvent en sortir beaucoup plus facilement par effet tunnel. De plus, cette réduction de l'épaisseur du diélectrique fait apparaître des défauts dans ce diélectrique, ces défauts favorisant la fuite des électrons au fur et à mesure des cycles d'écriture d'informations réalisés dans le dispositif mémoire. Un seul de ces défauts peut par exemple vider totalement la grille flottante des électrons qui y sont stockés.

Afin de résoudre les problèmes liés à la miniaturisation des dispositifs mémoires à grille flottante, et ainsi réaliser des dispositifs mémoires par exemple compatibles avec les noeuds technologiques inférieurs à 65 nm, d'autres architectures de dispositifs mémoires doivent donc être envisagées.

Il est par exemple connu de réaliser des dispositifs mémoires dans lesquels la grille flottante est remplacée par des nanocristaux de semi-conducteur. Ces nanocristaux forment des éléments discrets de stockage d'électrons. Le document « Fast and long retention-time nano-crystal memory » de Hanafi, H.I. et al., IEEE Transactions on Electron Devices, vol. 43, n°9, septembre 1996, pages 1553 à 1558, décrit la réalisation de dispositifs mémoires comportant des nanocristaux de silicium ou de germanium disposés dans une couche d'oxyde de commande formée entre le canal et la grille de commande, les nanocristaux étant isolés électriquement du substrat par un oxyde tunnel. Les nanocristaux sont formés par une implantation de silicium ou de germanium dans l'oxyde de commande puis un recuit à une température égale à environ 950°C. Un tel procédé de réalisation a toutefois les inconvénients majeurs de :
- nécessiter un budget thermique élevé incompatible avec les autres étapes de réalisation du dispositif lorsque l'on souhaite réaliser le dispositif mémoire par un procédé CMOS standard,
- être inefficace quant à la précipitation des atomes implantés en nanocristaux.

Le document « Modeling of the programming window distribution in multinanocrystals memories » de L. Perniola et al., IEEE Transactions on nanotechnology, vol. 2, n°4, décembre 2003, pages 277 à 284, décrit un procédé de réalisation de dispositifs mémoires à nanocristaux dans lequel les nanocristaux sont déposés par LP-CVD (dépôt chimique en phase vapeur à basse pression). Contrairement à la réalisation des nanocristaux par implantation et recuit, la formation des nanocristaux par LP-CVD permet d'éviter la mise en oeuvre d'une étape de recuit à haute température.

Toutefois, en réalisant les nanocristaux par dépôt LP-CVD ou par implantation et recuit, les tailles des nanocristaux obtenus présentent une dispersion relativement importante. De plus, ces techniques ne permettent pas d'obtenir des densités de nanocristaux supérieures à environ 10¹² cm⁻².

Le document US 2009/074950 A1 décrit un procédé de réalisation d'un dispositif mémoire à nanoparticules, dans lequel un dépôt de nanoparticules est réalisé à partir de nanoparticules dispersées dans un liquide.

### EXPOSÉ DE L'INVENTION

Un but de la présente invention est de proposer un procédé de réalisation d'un dispositif mémoire ne présentant pas les inconvénients de l'art antérieur, qui soit compatible avec les étapes d'un procédé CMOS, c'est-à-dire ne nécessitant pas un budget thermique important, et permettant d'obtenir un meilleur contrôle de la taille des sites de stockage d'électrons, ainsi qu'une densité plus importante des sites de stockage d'électrons dans le dispositif mémoire.

Pour cela, la présente invention propose un procédé de réalisation d'un dispositif mémoire à nanoparticules, comportant au moins les étapes de :
a) réalisation, dans un substrat à base d'au moins un semi-conducteur, de régions de source et de drain, et d'au moins un premier diélectrique sur au moins une zone du substrat disposée entre les régions de source et de drain et destinée à former un canal du dispositif mémoire,
b) dépôt d'au moins un liquide ionique, comprenant des nanoparticules d'au moins un matériau électriquement conducteur en suspension, recouvrant au moins ledit premier diélectrique,
c) formation d'un dépôt desdites nanoparticules au moins sur ledit premier diélectrique,
d) retrait du liquide ionique restant,
e) réalisation d'au moins un second diélectrique et d'au moins une grille de commande sur au moins une partie du dépôt de nanoparticules.

On entend par liquide ionique un sel organique ou un mélange de sels organiques dont le point de fusion est inférieur ou égal à environ 100°C, formant des associations de cations organiques et d'anions organiques ou inorganiques.

L'utilisation d'un liquide ionique dans le procédé selon l'invention pour la réalisation du dépôt de nanoparticules présente plusieurs avantages.

En effet, un liquide ionique possède une faible volatilité et une tension de vapeur très faible, contrairement aux solvants organiques volatils ou aux solvants aqueux. Les liquides ioniques sont donc plus facilement manipulables en faibles volumes, sans risque d'évaporation, à des températures beaucoup plus élevées, et éventuellement à des pressions beaucoup plus faibles, que les solvants organiques volatils. Les liquides ioniques présentent également une grande stabilité thermique, par exemple jusqu'à des températures supérieures à environ 400°C, et une grande stabilité chimique, ce qui est un avantage notamment d'un point de vue sécurité de mise en oeuvre de procédés industriels par rapport aux solvants organiques.

De plus, les liquides ioniques sont utilisables en électrochimie du fait de leur conductivité ionique et de leur large fenêtre électrochimique. Leurs propriétés physiques sont également modulables en fonction du type d'anions et de cations qui le composent. Leur large fenêtre électrochimique permet également la synthèse d'un large éventail de métaux, en particulier ceux non accessibles par exemple en électrochimie en milieu aqueux.

Le procédé selon l'invention permet également d'obtenir un très bon contrôle de la taille des nanoparticules dans le dispositif mémoire et donc de bien contrôler la distribution en tailles de ces nanoparticules car la synthèse de nanoparticules dans le liquide ionique, réalisée en amont du procédé de réalisation du dispositif mémoire, offre un très bon contrôle de la taille nominale des nanoparticules formées dans le liquide ionique. Le procédé selon l'invention permet donc d'obtenir un dépôt de nanoparticules mono-disperses, c'est-à-dire comportant toutes une taille sensiblement similaire à un ou deux atomes près (une nanoparticule pouvant comporter par exemple environ 100 atomes). Cela permet d'obtenir des nanoparticules dont les propriétés électriques, par exemple la conduction, sont homogènes sur l'ensemble des nanoparticules déposées.

L'utilisation d'un liquide ionique pour la réalisation du dépôt de nanoparticules offre en outre des propriétés de mouillage qui sont favorables à la pénétration de celui-ci dans des structures gravées submicroniques ainsi que de très bonnes propriétés rhéologiques favorisant le contrôle de l'étalement du liquide ionique, par exemple lors d'un dépôt de celui-ci par centrifugation (« spin coating » en anglais) ou par projection ou pulvérisation (« spraying » en anglais).

Le procédé selon l'invention permet d'obtenir un dispositif mémoire comportant un dépôt de nanoparticules ne se touchant pas entre elles, chaque nanoparticule formant une zone de stockage d'électrons indépendante des autres zones de stockage d'électrons formées par les autres nanoparticules. Ainsi, on améliore la rétention d'informations globale du dispositif mémoire car la présence de défauts dans les isolants entourant les nanoparticules n'affecte pas la rétention des électrons par les autres nanoparticules.

La réalisation des régions de source et de drain au cours de l'étape a) peut être obtenue par la mise en oeuvre des étapes suivantes :
a1) réalisation d'au moins une grille factice sur le substrat, au niveau de ladite zone destinée à former le canal du dispositif mémoire,
a2) implantation de dopants dans le substrat en utilisant la grille factice comme masque d'implantation, les zones dopées du substrat obtenues formant les régions de source et de drain,
la grille factice étant ensuite retirée avant la mise en oeuvre de l'étape b).

On peut ainsi réaliser un dépôt de nanoparticules et une grille de commande auto-alignés par rapport aux régions de source et de drain.

Le procédé peut comporter en outre, entre l'étape a2) et l'étape de retrait de la grille factice, les étapes suivantes :
- réalisation d'espaceurs à base d'au moins un matériau diélectrique contre les flancs latéraux de la grille factice,
- dépôt d'au moins une couche d'enrobage sur la grille factice, les espaceurs et les régions de source et de drain,
- planarisation de la couche d'enrobage avec arrêt sur la grille factice.

Le procédé peut comporter en outre, entre l'étape de retrait de la grille factice et l'étape b) de dépôt du liquide ionique, ou entre l'étape de retrait de la grille factice et la réalisation du premier diélectrique, une étape de gravure d'au moins une partie des espaceurs en contact avec le substrat, formant des creux sous une partie restante des espaceurs, le liquide ionique étant également déposé, au cours de l'étape b), dans lesdits creux, et les nanoparticules étant également déposées, au cours de l'étape c), au niveau de zones du substrat situées dans lesdits creux. Les nanoparticules peuvent être séparées du substrat par un isolant tunnel, le premier diélectrique étant également formé dans lesdits creux.

Ainsi, il est possible de former le dépôt de nanoparticules jusque sous d'éventuels creux ou espaces formés sous les espaceurs latéraux, pouvant ainsi recouvrir une partie des zones de source et drain à proximité de la jonction entre ces régions et le canal.

Le procédé peut comporter en outre, entre l'étape de réalisation des espaceurs et l'étape de dépôt de la couche d'enrobage, une étape de siliciuration d'au moins une partie des régions de source et de drain. Le terme « siliciuration » correspond, ici et dans tout le reste du document, à la réalisation d'un composé à base de semi-conducteur et de métal et n'est pas limité à la seule réalisation de siliciure, c'est-à-dire d'un composé de silicium et de métal. Le terme « siliciuration » sera employé même lorsque le substrat est à base d'un semi-conducteur autre que du silicium.

L'étape c) de formation du dépôt de nanoparticules peut comporter au moins une étape d'incubation du substrat et du liquide ionique pendant une durée comprise entre environ cinq minutes et une heure, ou entre environ une minute et une heure, ou supérieure ou égale à environ une minute.

Une différence de potentiels électriques non nulle peut être appliquée entre le substrat et le liquide ionique au cours d'au moins une partie de l'étape c) de formation du dépôt de nanoparticules.

Dans un mode de réalisation particulier, la différence de potentiels électriques peut être appliquée, par exemple via le substrat, entre la région de source et/ou de drain et le liquide ionique. Ainsi, la densité de nanoparticules déposées au voisinage des régions de source et/ou de drain peut être supérieure à la densité de dépôt de nanoparticules obtenue sur les autres zones. Cette configuration particulière du dépôt de nanoparticules dans le dispositif mémoire permet notamment de réaliser un dispositif mémoire à plusieurs niveaux de mémorisation, c'est-à-dire comportant plusieurs niveaux d'énergie de piégeage des électrons, ce qui permet de mémoriser une information sur plusieurs bits dans un seul dispositif mémoire. Cette configuration permet notamment de :
- pouvoir injecter des charges de l'électrode de drain (ou de source) vers les nanoparticules de façon beaucoup plus fiable que dans les procédés de l'art antérieur,
- doubler la capacité de mémorisation par rapport aux dispositifs mémoires multiniveaux de l'art antérieur grâce à sa capacité d'écriture d'informations d'un côté ou de l'autre du canal, c'est-à-dire dans les nanoparticules se trouvant soit du côté de la source, soit du côté du drain.

L'étape d) de retrait du liquide ionique peut comporter une étape de rinçage par un solvant et une étape de séchage, ou une étape de dégradation par un traitement thermique à une température comprise entre environ 200°C et 500°C. La réalisation d'un traitement thermique pour éliminer l'excès de liquide ionique permet notamment de maximiser la densité des nanoparticules déposées. Dans le cas d'une élimination du liquide ionique restant par une dégradation par traitement thermique, cette dégradation peut être assistée par une source d'énergie, par exemple une source de rayons ultraviolets, éclairant le liquide ionique lors de la dégradation thermique.

L'étape e) de réalisation du second diélectrique et de la grille de commande peut être obtenue par la mise en oeuvre des étapes suivantes :
e1) dépôt d'une couche à base d'un matériau diélectrique au moins sur le dépôt de nanoparticules,
e2) dépôt d'une couche à base d'un matériau électriquement conducteur sur la couche à base du matériau diélectrique,
e3) planarisation d'au moins ladite couche à base du matériau électriquement conducteur et de ladite couche à base du matériau diélectrique.

De préférence, le liquide ionique peut comporter au moins un cation de type imidazolium porteur de substituants alkyles. Un tel liquide ionique permet notamment d'améliorer la répétitivité concernant le contrôle de la taille des nanoparticules, la taille d'un substituant alkyle correspondant à une taille d'une nanoparticule dans le liquide ionique.

Le liquide ionique peut être choisi parmi du BMIMNTf₂, du HMIMNTf₂ ou du OMIMNTf₂, et/ou les nanoparticules en suspension dans le liquide ionique peuvent être à base de ruthénium, ou tout autre matériau électriquement conducteur adapté à la réalisation du dépôt de nanoparticules.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 9 représentent les étapes d'un procédé de réalisation d'un dispositif mémoire à nanoparticules, objet de la présente invention, selon un premier mode de réalisation,
- les figures 10 et 11 représentent un dispositif mémoire à nanoparticules obtenu par la mise en oeuvre d'un procédé de réalisation de dispositif mémoire à nanoparticules, objet de la présente invention, selon un second mode de réalisation,
- la figure 12 représente un dispositif mémoire à nanoparticules obtenu par la mise en oeuvre d'un procédé de réalisation de dispositif mémoire à nanoparticules, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

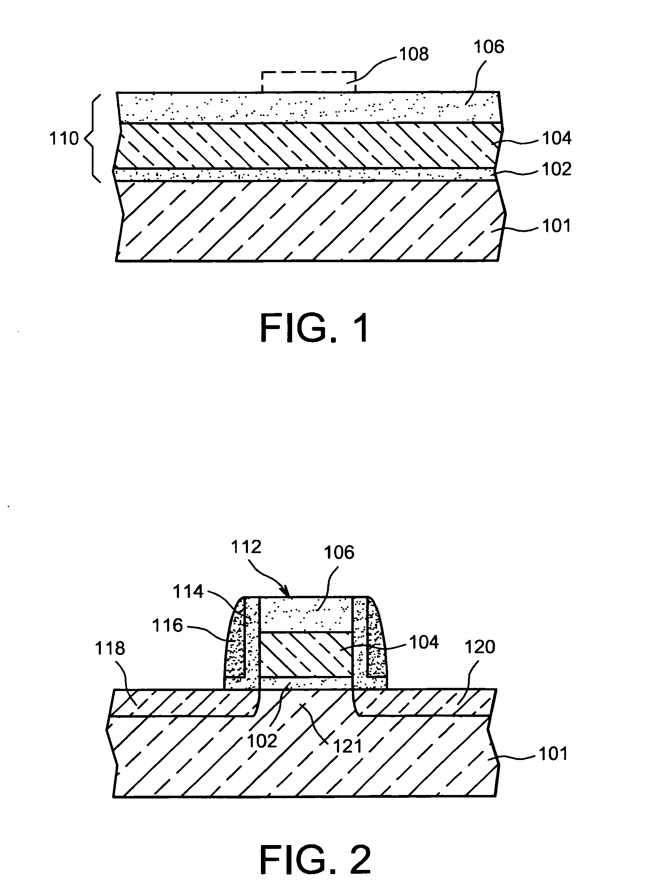

On se réfère aux figures 1 à 9 qui représentent les étapes d'un procédé de réalisation d'un dispositif mémoire 100 à nanoparticules selon un premier mode de réalisation.

Le dispositif mémoire 100 est ici réalisé à partir d'un substrat 101 à base de semi-conducteur, par exemple du silicium, dont une face a été préalablement oxydée afin de former une couche diélectrique 102 par exemple à base d'oxyde de silicium. Une couche 104, par exemple à base de silicium polycristallin ou amorphe, est ensuite déposée sur la couche d'oxyde 102, puis une couche de nitrure de silicium 106 est déposée sur la couche 104 de silicium. Dans une variante, la couche 104 pourrait être à base de nitrure de silicium et la couche 106 à base de silicium polycristallin ou amorphe. Les couches 102, 104 et 106 forment ensemble un empilement 110 dont l'épaisseur est par exemple comprise entre environ 100 nm et 500 nm et correspond sensiblement à l'épaisseur de la structure composée d'un dépôt de nanoparticules et d'une grille de commande du dispositif mémoire 100 obtenu à la fin du procédé.

Dans une variante de ce premier mode de réalisation, le dispositif mémoire 100 pourrait être réalisé directement à partir d'un substrat de type SOI ou semi-conducteur sur isolant.

Un masque de gravure 108, représenté en trait discontinu sur la figure 1, est réalisé sur la couche 106 de nitrure de silicium par exemple par dépôt d'une couche de résine photosensible et gravure de cette couche. Le masque 108 est disposé au niveau de l'emplacement d'une grille factice que l'on souhaite réaliser dans l'empilement 110. De plus, la taille et la forme du masque 108 correspondent à la taille et la forme de cette grille factice.

Les couches 102, 104 et 106 sont gravées afin que seules les portions de ces couches se trouvant sous le masque 108 subsistent après la gravure. Les portions restantes des couches 102, 104 et 106, c'est-à-dire de l'empilement 110, forment le corps de la grille factice désignée par la référence 112 sur la figure 2.

On réalise ensuite une première implantation ionique à faible dose dans le substrat 101, au niveau de régions 118 et 120 destinées à former les régions de source et de drain du dispositif mémoire 100. Les éléments dopants implantés sont par exemple des ions de bore, de phosphore ou encore d'arsenic, choisis en fonction du type de conductivité (N ou P) du substrat 101. Cette implantation est par exemple réalisée à une dose comprise entre environ 10¹³ et 10¹⁵ at/cm², avec une énergie comprise entre environ 3 et 25 keV.

Cette première implantation ionique est suivie par la réalisation, contre le ou les flancs latéraux de la grille factice 112, d'espaceurs latéraux 114, 116 représentés sur la figure 2. Chacun de ces espaceurs comporte une première portion d'oxyde de silicium 114 disposée contre les flancs latéraux des couches 102, 104 et 106 de la grille factice 112, permettant de limiter les contraintes de contact avec la grille factice 112, et notamment avec le silicium de la couche 104. Cette première portion d'oxyde de silicium 114 permet également de limiter les contraintes de contact avec la portion du substrat 101 avec laquelle elle est en contact. Une seconde portion 116, par exemple à base de nitrure de silicium, recouvre chaque portion d'oxyde de silicium 114, et permet de protéger la grille factice 112 des traitements ultérieurs du procédé et en particulier du traitement de siliciuration des régions de source et de drain 118, 120. Ces espaceurs latéraux 114, 116 peuvent être obtenus après la mise en oeuvre de dépôts pleine plaque d'oxyde de silicium et de nitrure de silicium, puis une gravure anisotrope de ces matériaux pour ne laisser subsister que des portions de ces couches sur les flancs latéraux de la grille factice 112.

On réalise ensuite, après la formation des espaceurs latéraux 114, 116, une deuxième implantation ionique, à des doses supérieures à celles de la première implantation ionique, par exemple comprises entre environ 10¹⁴ et 5.10¹⁵ at/cm². Cette deuxième implantation utilise alors la grille factice et les espaceurs latéraux comme masque d'implantation. Dans ce cas, les régions 118 et 120 forment des régions de source et de drain dopées graduellement, c'est-à-dire dont le dopage diminue en allant vers un canal 121 formé par la zone du substrat 101 se trouvant sous la grille factice 112, entre les régions de source et de drain 118, 120. On obtient ainsi des régions de source et de drain 118, 120 en partie à base de semi-conducteur dégénéré au niveau des zones ayant subi cette seconde implantation ionique.

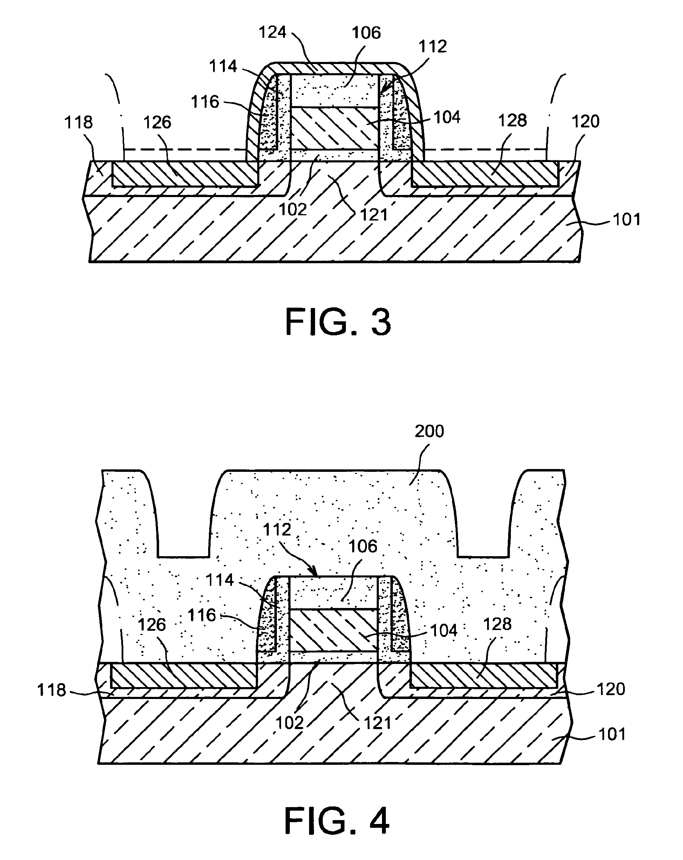

Comme représenté sur la figure 3, on réalise ensuite une siliciuration sélective du substrat 101 au niveau des régions de source et de drain 118, 120. Cette siliciuration est réalisée en déposant tout d'abord une couche 124 à base d'un métal tel que du titane, du cobalt ou encore du nickel, puis en réalisant un traitement thermique à une température suffisante pour provoquer une réaction de siliciuration entre le silicium du substrat 101 et le métal de la couche 124, cette température étant par exemple comprise entre environ 150°C et 800°C. Cette siliciuration permet notamment d'augmenter localement la conductivité des régions de source et de drain, et donc de réduire leur résistance d'accès.

La siliciuration est ici qualifiée de sélective dans la mesure où elle est limitée aux zones dans lesquelles le métal de la couche 124 est directement en contact avec du silicium. On peut observer sur la figure 3 que la couche de métal 124 a disparu au-dessus des régions de source et de drain 118, 120 pour y former des couches superficielles 126, 128 de siliciure dans les régions de source et de drain, dans le substrat 101. Une portion restante de la couche de métal 124 est toutefois présente sur les espaceurs latéraux 114, 116 et sur la grille factice 112 après la mise en oeuvre du traitement thermique, cette portion métallique restante n'ayant pas réagi avec les matériaux avec lesquels elle est en contact. Sur la figure 3, des traits mixtes présents aux extrémités de la figure 3 représentent d'autres grilles factices éventuellement réalisées sur le substrat 101.

Comme représenté sur la figure 4, on supprime la portion restante de la couche de métal 124 puis on réalise ensuite un enrobage par une couche 200 de l'ensemble de la structure précédemment réalisée. Cette couche d'enrobage 200 a ici une épaisseur supérieure à la hauteur de la grille factice 112, c'est-à-dire à l'épaisseur totale des couches 102, 104 et 106. Le matériau de la couche d'enrobage 200 est à base d'un matériau diélectrique, par exemple de l'oxyde de silicium, ou encore à base d'un matériau électriquement conducteur si l'on souhaite que des portions de cette couche d'enrobage 200 se trouvant en contact avec les régions de source et de drain forment des interconnexions électriques de ces régions.

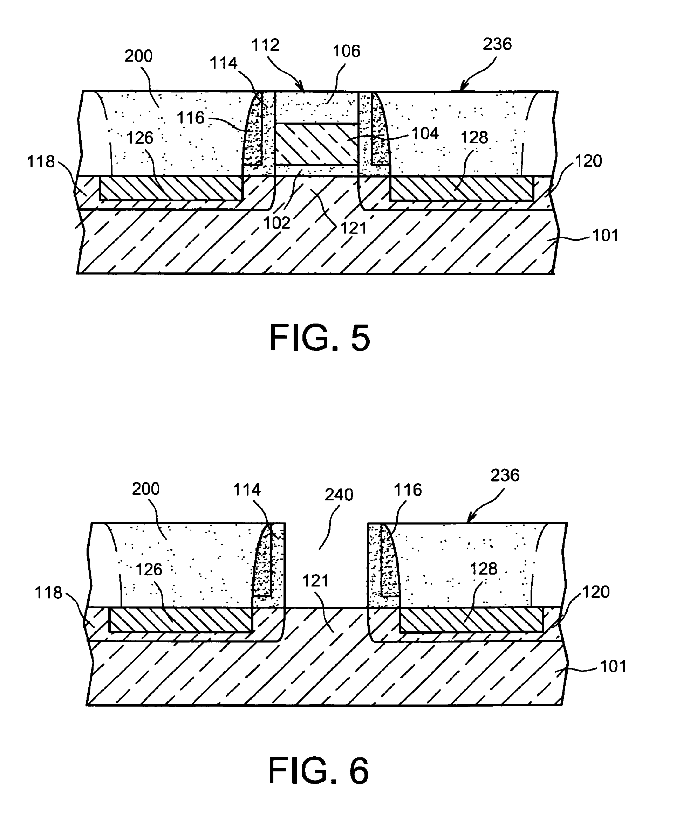

On réalise ensuite une planarisation de la couche d'enrobage 200 avec arrêt sur la couche 106 de nitrure de silicium, conférant à la couche d'enrobage 200 une surface plane 236 (voir figure 5). Lorsque le matériau de la couche d'enrobage 200 est électriquement conducteur, cette planarisation permet d'isoler électriquement l'une de l'autre les régions de source et de drain.

Comme représenté sur la figure 6, on élimine ensuite la grille factice 112 pour former un trou 240 délimité par les premières portions 114 des espaceurs latéraux et entouré par la couche d'enrobage 200. L'élimination de la grille factice 112 comprend par exemple la gravure successive des couches 102, 104 et 106 formant la grille factice 112.

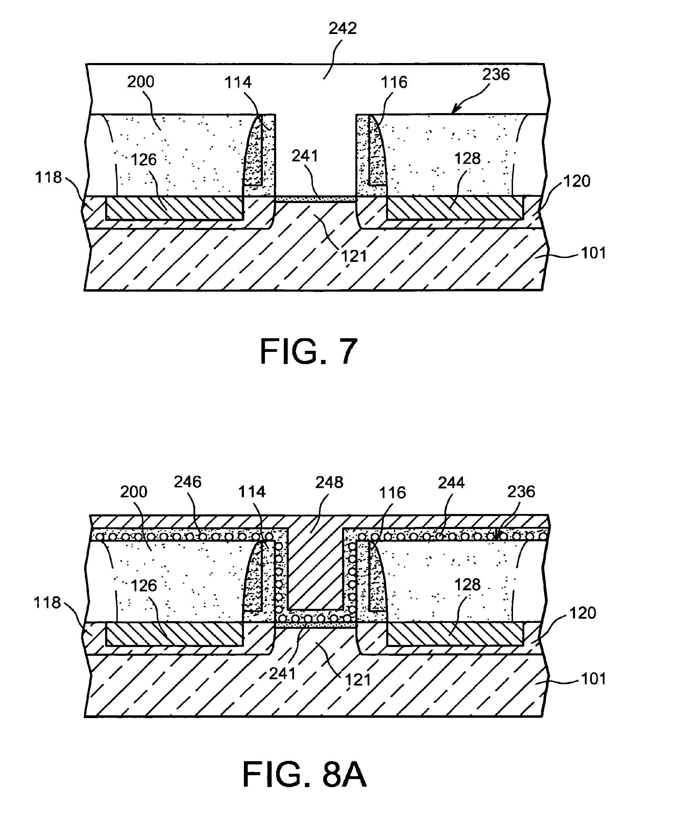

On réalise ensuite, au niveau de la paroi de fond du trou 240, un premier diélectrique 241, à base d'un matériau diélectrique tel que par exemple de l'oxyde de silicium obtenu par oxydation de la partie du substrat 101 formant la paroi de fond du trou 240 (figure 7). Ce premier diélectrique 241 a par exemple une épaisseur inférieure ou égale à environ 10 nm. Dans une variante de réalisation, ce premier diélectrique 241 pourrait également être obtenu par dépôt d'une couche d'oxyde de silicium ou de tout autre matériau diélectrique approprié. Dans le cas d'un dépôt, le premier diélectrique 241 peut alors recouvrir la paroi de fond du trou 240, les autres parois latérales du trou 240 ainsi que la surface 236 et les espaceurs latéraux. Ce premier diélectrique 241 permet d'isoler électriquement le canal 121 du futur dépôt de nanoparticules du dispositif 100 qui sera formé sur le premier diélectrique 241. Dans une variante, le premier diélectrique 241 pourrait également être à base de SiO_{X}N_{Y}, HfO₂, HfZr_{X}O_{Y} ou encore de HfAl_{X}La_{Y}Zr_{Z}OₜNᵤ. Il est également possible que le premier diélectrique 241 soit à base d'un diélectrique présentant des propriétés polaires afin de faciliter un dépôt sélectif des nanoparticules métalliques sur ce premier diélectrique 241.

On étale ensuite sur l'ensemble de la structure précédemment réalisée, par exemple par la mise en oeuvre d'un dépôt par centrifugation ou par pulvérisation, un liquide ionique 242 dans lequel des nanoparticules métalliques ont été synthétisées.

Les nanoparticules sont des agrégats de quelques dizaines, centaines ou milliers d'atomes de métaux de transition (ruthénium, rhodium, palladium, etc, ...) présentant des géométries variables et dont les dimensions sont de l'ordre de quelques nanomètres, par exemple comprises entre environ 0,5 nm et 10 nm. La présence d'un nombre important d'atomes en surface des nanoparticules leurs confère des propriétés magnétiques, électroniques et catalytiques à la frontière entre l'état moléculaire et l'état massique.

La synthèse des nanoparticules dans un liquide ionique peut être réalisée en mettant en solution un complexe organométallique dans un liquide ionique matrice sous agitation à température ambiante puis en refroidissant le milieu réactionnel à une température proche de 0°C. Le milieu est pressurisé sous hydrogène pendant un temps compris entre quelques heures et quelques jours (en fonction des complexes) jusqu'à l'obtention d'une suspension de nanoparticules métalliques.

Par liquide ionique matrice, on entend un liquide ionique à température ambiante capable de solubiliser une ou plusieurs espèces chimiques telles que les sels minéraux ou organiques, ou les molécules organiques ou organométalliques. Ce liquide ionique comportant les nanoparticules en suspension peut être utilisé pur ou être mélangé avec un ou plusieurs autres liquides ioniques fonctionnalisés (par exemple une amine, un alcool, un thiol ou un éther) ou non. Le liquide ionique peut également être mélangé à un autre solvant hydrophobe.

On décrit ci-dessous trois exemples de réalisation de synthèses de nanoparticules métalliques dans des liquides ioniques, les liquides ioniques obtenus, qui comportent des nanoparticules métalliques en suspension, pouvant être utilisés dans le procédé de réalisation du dispositif mémoire décrit ici.

### Exemple de synthèse de nanoparticules de ruthénium dans un liquide ionique du type BMIMNTf₂ :

Dans une boîte à gants, c'est-à-dire une boîte hermétique sous atmosphère contrôlée (par exemple sous atmosphère d'argon) dans laquelle les manipulations sont réalisées avec des gants, on introduit dans un autoclave en verre 10 ml de bis(trifluoromethanesulfonyl)imide 1-butyl-3-methyl imidazolium (BMIMNTf₂). On y dissout ensuite totalement, à température ambiante et sous forte agitation pendant 1 heure, du Ru(COD)(COT) (135 mg, 0,43 mmol, C=0,043 mol/L). Lorsqu'une solution homogène est obtenue, le milieu réactionnel est refroidi à une température égale à environ 0°C et l'agitation est arrêtée. La température du milieu est stabilisée à environ 0°C. L'autoclave est alors balayé sous courant d'hydrogène puis pressurisé sous hydrogène à 4 bars pendant 72 heures. Le milieu est alors évacué sous vide pour éliminer le cyclooctane (COA) formé. Une suspension colloïdale noire de nanoparticules de ruthénium, dont chacune a un diamètre égale à environ 1,1 nm +/ 0,2 nm, dispersées de façon homogène sans aucune agglomération et dont la distribution des tailles est très étroite, est obtenue.

La suspension de nanoparticules de ruthénium obtenue dans le liquide ionique est stable plusieurs mois lorsque celle-ci est disposée sous atmosphère d'argon, à température ambiante. De plus, même en réalisant une centrifugation de la solution obtenue ou en réalisant une précipitation par des solvants organiques (alcanes, dichlorométhane, acétonitrile), aucune décantation des nanoparticules de ruthénium n'est observée dans le liquide ionique.

### Exemple de synthèse de nanoparticules de ruthénium dans un liquide ionique du type HMIMNTf₂ :

Dans une boîte à gants, on introduit dans un autoclave en verre 10 ml de bis(trifluoromethanesulfonyl)imide 1-hexyl-3-methyl imidazolium (HMIMNTf₂). On y dissout ensuite totalement, à température ambiante et sous forte agitation pendant 1 heure, du Ru(COD)(COT) (135 mg, 0,43 mmol, C=0,043 mol/L). Lorsqu'une solution homogène est obtenue, le milieu réactionnel est refroidi à une température égale à environ 0°C et l'agitation est arrêtée. La température du milieu est stabilisée à environ 0°C. L'autoclave est alors balayé sous courant d'hydrogène puis pressurisé sous hydrogène à 4 bars pendant 72 heures. Le milieu est alors évacué sous vide pour éliminer le cyclooctane (COA) formé. Une suspension colloïdale noire de nanoparticules de ruthénium, dont chacune a un diamètre égale à environ 1,9 nm +/ 0,2 nm, dispersées de façon homogène sans aucune agglomération et dont la distribution des tailles est très étroite, est obtenue.

Là encore, la suspension de nanoparticules de ruthénium obtenue dans le liquide ionique est très stable plusieurs mois lorsque celle-ci est disposée sous atmosphère d'argon, à température ambiante. De plus, même en réalisant une centrifugation de la solution obtenue ou en réalisant une précipitation par des solvants organiques (alcanes, dichlorométhane, acétonitrile), aucune décantation des nanoparticules de ruthénium n'est observée dans le liquide ionique.

### Exemple de synthèse de nanoparticules de ruthénium dans un liquide ionique du type OMIMNTf₂ :

Dans une boîte à gants, on introduit dans un autoclave en verre 10 ml de bis(trifluoromethanesulfonyl)imide 1-octyl-3-methyl imidazolium (OMIMNTf₂). On y dissout ensuite totalement, à température ambiante et sous forte agitation pendant 1 heure, du Ru(COD)(COT) (135 mg, 0,43 mmol, C=0,043 mol/L). Lorsqu'une solution homogène est obtenue, le milieu réactionnel est refroidi à une température égale à environ 0°C et l'agitation est arrêtée. La température du milieu est stabilisée à environ 0°C. L'autoclave est alors balayé sous courant d'hydrogène puis pressurisé sous hydrogène à 4 bars pendant 72 heures. Le milieu est alors évacué sous vide pour éliminer le cyclooctane (COA) formé. Une suspension colloïdale noire de nanoparticules de ruthénium, dont chacune a une taille égale à environ 1,9 nm +/ 0,2 nm, dispersées de façon homogène sans aucune agglomération et dont la distribution des tailles est très étroite, est obtenue.

Là encore, la suspension de nanoparticules de ruthénium obtenue dans le liquide ionique est très stable plusieurs mois lorsque celle-ci est disposée sous atmosphère d'argon, à température ambiante. De plus, même en réalisant une centrifugation de la solution obtenue ou en réalisant une précipitation par des solvants organiques (alcanes, dichlorométhane, acétonitrile), aucune décantation des nanoparticules de ruthénium n'est observée dans le liquide ionique.

Les liquides ioniques, ainsi que leurs procédés de fabrication, décrits dans le document « Room Temperature Ionic Liquids, Solvents for Synthesis and Catalysis » de Thomas Welton, Chem. Rev, 1999, vol. 99, n°8, pages 2071-2084, peuvent également être utilisés pour la mise en oeuvre du procédé de réalisation du dispositif mémoire décrit ici.

Après avoir étalé sur l'ensemble de la structure le liquide ionique 242 dans lequel des nanoparticules métalliques ont été synthétisées, on laisse incuber l'ensemble, par exemple à température ambiante et pendant une durée comprise entre environ 1 minute et 1 heure, afin de former un dépôt des nanoparticules 244 se trouvant initialement dans le liquide ionique 242 contre les parois du trou 240 ainsi que sur les espaceurs 114, 116 et sur la face supérieure 236 du matériau d'enrobage 200. Ces nanoparticules 244 sont par exemple composées d'une centaine d'atomes chacune. Dans l'exemple décrit ici, les nanoparticules 244 ont chacune un diamètre sensiblement égal à environ 2 nm et sont espacées les unes des autres d'une distance sensiblement équivalente à leur diamètre, c'est-à-dire environ 2 nm. La densité des nanoparticules 244 obtenue est donc par exemple égale à environ 5.10¹³ cm⁻².

La durée d'incubation est choisie en fonction de la densité de nanoparticules souhaitée : plus cette durée d'incubation est longue, plus la densité des nanoparticules 244 déposées sera importante. La densité de nanoparticules 244 déposées dépend de manière générale de la cinétique d'adsorption des nanoparticules du liquide ionique 242 sur la surface avec laquelle le liquide ionique 242 est en contact. Ainsi, outre la durée d'incubation, la quantité de nanoparticules 244 déposées sur une surface est dépendante de la constante d'affinité entre les nanoparticules et cette surface, cette constante d'affinité étant égale au rapport de la constante cinétique d'association sur la constante cinétique de dissociation de la réaction d'adsorption, de la concentration initiale en nanoparticules dans le liquide ionique 242, de la densité de sites réactionnels sur la surface sur laquelle on cherche à réaliser le dépôt, ou encore du coefficient de diffusion des nanoparticules dans le milieu donné.

On retire ensuite l'excédent de liquide ionique, par exemple par un rinçage à l' éthanol à 95 % suivi d'un séchage à l'argon, afin de ne conserver que le dépôt de nanoparticules 244 et éliminer les restes de solvants. Il est également possible de retirer l'excès de liquide ionique en réalisant une dégradation par un traitement thermique à une température comprise entre environ 200°C et 500°C.

Une couche 246 à base d'un diélectrique de forte permittivité (high-κ), c'est-à-dire dont la permittivité est supérieure à environ 3,9, est ensuite formée sur les nanoparticules 244. Ce diélectrique à forte permittivité est par exemple de l'Al₂O₃, du TiO₂, du HfO₂ ou du Ba_{X}Sr₁₋ₓTiO₃ (BST). Ce matériau diélectrique peut par exemple être choisi tel que celui-ci présente une constante diélectrique supérieure à celle du matériau du premier diélectrique 241. Dans une variante, cette couche diélectrique 246 pourrait être remplacée par un empilement de sous-couches diélectriques, par exemple un empilement de type oxyde/nitrure/oxyde. L'épaisseur totale du dépôt de nanoparticules 244 et de la couche diélectrique 246 est ici inférieure à la profondeur du trou 240, c'est-à-dire inférieure à la hauteur de la grille factice précédemment éliminée. Un matériau conducteur 248, destiné à former par la suite la grille de commande du dispositif 100, est déposé sur l'ensemble de la structure, comblant notamment la partie du trou 240 encore non occupée par les nanoparticules 244 et la couche diélectrique 246 précédemment déposés (voir figure 8A). Ce matériau conducteur est par exemple choisi parmi les matériaux suivants : polysilicium, W, TaN, W/TiN, Ti, Cu/TaN, W/Nb, W/RuO₂. Il est également possible que le matériau conducteur 248 soit formé par un empilement de plusieurs sous-couches à base de tels matériaux ou tout autre matériau adapté pour la réalisation de la grille de commande.

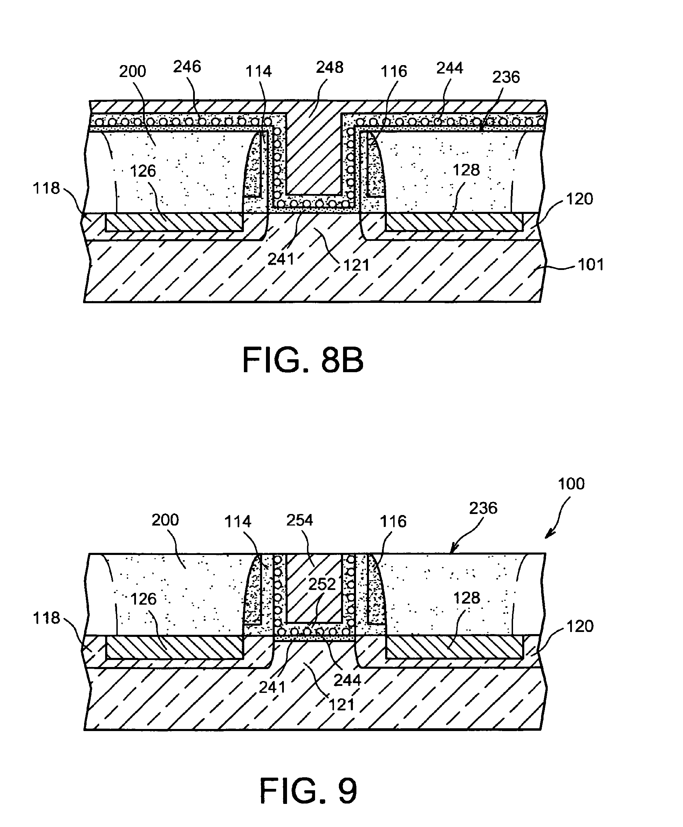

En variante, la figure 8B représente la structure obtenue lorsque le premier diélectrique 241 est réalisé par un dépôt recouvrant la paroi de fond du trou 240, les autres parois latérales du trou 240, la surface 236 et les espaceurs latéraux.

Comme représenté sur la figure 9, on réalise un polissage des couches 246 et 248 et du dépôt de nanoparticules 244 précédemment réalisés avec arrêt sur la surface 236 du matériau d'enrobage 200. Le dispositif mémoire 100 ainsi obtenu comporte donc un dépôt de nanoparticules 244 formé au-dessus du premier diélectrique 241, ainsi qu'une portion électriquement conductrice 254 formant la grille de commande du dispositif mémoire 100 et formée par la portion restante du matériau conducteur 248. De plus, un second diélectrique 252 est formé par la portion restante de la couche 246 et isole électriquement la grille de commande 254 du dépôt de nanoparticules 244.

Il est ensuite possible de mettre en oeuvre des étapes de réalisation d'interconnexions reliant électriquement la source, le drain, et la grille de commande à des éléments extérieurs au dispositif mémoire 100.

La figure 9, qui correspond à un plan de coupe du dispositif 100 passant par la source et le drain, montre la forme en U, dans le plan de coupe représenté sur la figure 9, de l'ensemble formé par le dépôt de nanoparticules 244 et le second diélectrique 252. Les nanoparticules 244 sont séparées et isolées de la grille de commande 254 par le second diélectrique 252. Les nanoparticules 244 entourent donc la grille de commande 254 sur trois côtés, c'est-à-dire ici celui se trouvant du côté du canal 121 et les deux côtés latéraux perpendiculaires au substrat 101.

Dans le cas où le premier diélectrique 241 est obtenu par un dépôt de diélectrique, le polissage peut être réalisé avec arrêt sur la surface 236, comme dans l'exemple représenté sur la figure 9, ou avec arrêt sur la surface de la couche diélectrique 241 se trouvant sur la surface 236.

Dans une variante du procédé décrit précédemment, il est possible de réaliser, préalablement à l'étalement du liquide ionique 242 comprenant les nanoparticules métalliques, une fonctionnalisation de la surface contre laquelle le dépôt de nanoparticules est destiné à être réalisé. Une telle fonctionnalisation permet d'apporter un groupement terminal sur le substrat qui peut interagir avec les particules métalliques, ce qui peut modifier la cinétique de réaction d'adsorption des particules, leur densité surfacique et leur stabilité sur la surface lors d'une étape de rinçage du substrat. Cette fonctionnalisation peut être réalisée par exemple par silanisation ou électrogreffage de sels de diazonium (dans ce cas, l'épaisseur de la couche diélectrique est de préférence inférieure à environ 10 nm). Les groupements terminaux peuvent être par exemple choisis parmi du thiol, du carboxylate, de l'acide carboxylique, de l'amine, de l'ammonium, du thioester, du thiourée, etc.

Dans une variante du premier mode de réalisation du procédé précédemment décrit, il est possible, après l'étalement du liquide ionique 242, de polariser la face arrière du substrat 101 vis-à-vis du liquide ionique 242, afin de réaliser un dépôt sélectif des nanoparticules 244 sur le premier diélectrique 241 dont l'épaisseur peut être inférieure à celles des espaceurs latéraux 114, 116. Cette variante peut s'appliquer lorsque le premier diélectrique 241 est obtenu par oxydation du substrat 101 ou lorsque le premier diélectrique 241 est obtenu par dépôt. En appliquant une différence de potentiels entre le substrat 101 et le liquide ionique 242, un champ électrique plus intense est présent au niveau du premier diélectrique 241 qu'au niveau des espaceurs latéraux 114, 116 car le premier diélectrique 241 a une épaisseur inférieure à celle des espaceurs latéraux. Cette différence de champ électrique permet d'augmenter la vitesse de dépôt des nanoparticules sur le premier diélectrique 241 par rapport à celle au niveau des espaceurs latéraux 114, 116, et favorise ainsi le dépôt des nanoparticules contenus dans le liquide ionique 242 sur le premier diélectrique 241. On réalise ainsi un dépôt quasi sélectif des nanoparticules 244 sur le premier diélectrique 241. Contrairement au dispositif mémoire 100 représenté sur la figure 9, le dispositif mémoire ayant subi une telle polarisation du substrat ne comporte donc pas de nanoparticules déposées contre les parois latérales des espaceurs 114, 116, les nanoparticules étant uniquement déposées au fond du trou obtenu par le retrait de la grille factice, contre le premier diélectrique 241. Dans cette variante de réalisation, le premier diélectrique 241 peut notamment être à base d'un matériau présentant des propriétés polaires afin de faciliter la formation des nanoparticules contre le premier diélectrique 241.

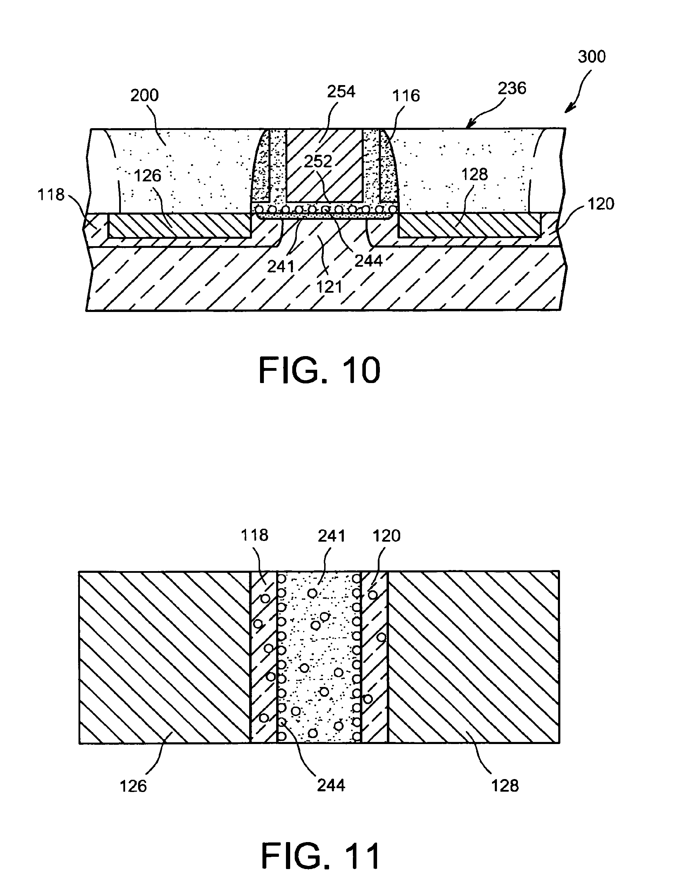

On décrit maintenant la réalisation d'un dispositif mémoire 300, représenté sur la figure 10, obtenu par la mise en oeuvre du procédé de réalisation de dispositif mémoire selon un second mode de réalisation.

Tout d'abord, on met en oeuvre les étapes précédemment décrites du procédé selon le premier mode de réalisation en liaison avec les figures 1 à 6.

On réalise alors une gravure des premières portions d'oxyde de silicium 114 des espaceurs latéraux. Le matériau des premières portions 114 est notamment choisi afin de pouvoir les graver sélectivement par rapport aux secondes portions 116 des espaceurs latéraux. On forme ainsi, sous les secondes portions 116, des creux dans lesquels des nanoparticules sont destinées à être réalisées. On réalise ensuite le premier diélectrique 241 de manière analogue au premier mode de réalisation, c'est-à-dire soit par oxydation (cas de la figure 10), soit par dépôt dans le trou 240, le premier diélectrique 241 étant dans ce cas également déposé contre les parois se trouvant dans les creux formés sous les secondes portions 116 des espaceurs latéraux.

On étale ensuite sur l'ensemble de la structure précédemment réalisée, par exemple par la mise en oeuvre d'un dépôt par centrifugation ou par pulvérisation, le liquide ionique 242 dans lequel des nanoparticules métalliques ont été synthétisées. Par rapport au premier mode de réalisation, le liquide ionique s'étale également dans le creux précédemment formés sous les secondes portions 116 des espaceurs latéraux.

On réalise alors l'incubation de l'ensemble afin de former un dépôt de nanoparticules contre le premier diélectrique 241, mais également dans les creux, sous les secondes portions 116 des espaceurs latéraux. De plus, lors de l'incubation, une différence de potentiels électriques est appliquée entre le liquide ionique 242 et les régions de source et de drain 118, 120. En réalisant une telle polarisation, on favorise la formation des nanoparticules sous les secondes portions 116 des espaceurs latéraux. Les nanoparticules 244 déposées se retrouvent donc principalement concentrées au niveau de la jonction entre le canal 121 et les régions de source et de drain 118, 120. La figure 11 représente une vue schématique du dépôt de nanoparticules 244 obtenu sur le substrat 101 avec ce second mode de réalisation. Sur cette figure 11, on voit que les nanoparticules 244 sont principalement déposées à la jonction entre le premier diélectrique 241 et les régions de source et de drain 118, 120. Le second diélectrique 252 et la grille de commande 254 sont ensuite réalisés de manière analogue au premier mode de réalisation.

Ce procédé de réalisation selon le second mode de réalisation permet donc d'optimiser les architectures des dispositifs mémoires employant la programmation par électrons chauds. On favorise ainsi le dépôt de nanoparticules au-dessus des régions de source et de drain ayant un travail de sortie distinct de celui du canal.

Ce second mode de réalisation permet de bien contrôler l'injection des porteurs de charge dans les « pseudo grilles flottantes », formées par les nanoparticules 244, se situant à l'aplomb des régions de source et de drain 118, 120, sous les espaceurs latéraux. On contrôle ainsi encore mieux les dispersions de caractéristiques des dispositifs mémoires réalisés. Ce procédé selon le second mode de réalisation est donc particulièrement adapté pour la réalisation de dispositifs mémoires multi-niveaux par exemple décrits dans le document WO 98/03977, étant donné que la disposition des nanoparticules 244 d'un côté ou de l'autre du canal permet de doubler la capacité de stockage des dispositifs mémoires ainsi réalisés, les informations pouvant être stockées dans les nanoparticules se trouvant du côté de la source ou dans les nanoparticules se trouvant du côté du drain.

Dans une variante de ce second mode de réalisation, il est possible de concentrer les nanoparticules déposées que d'un seul côté du canal, c'est-à-dire soit du côté de la source soit du côté du drain, en ne polarisant que l'une de ces deux régions par rapport au liquide ionique. Le dépôt de nanoparticules obtenu n'est donc plus symétrique par rapport au canal, contrairement aux dépôts de nanoparticules des dispositifs mémoires précédemment décrits.

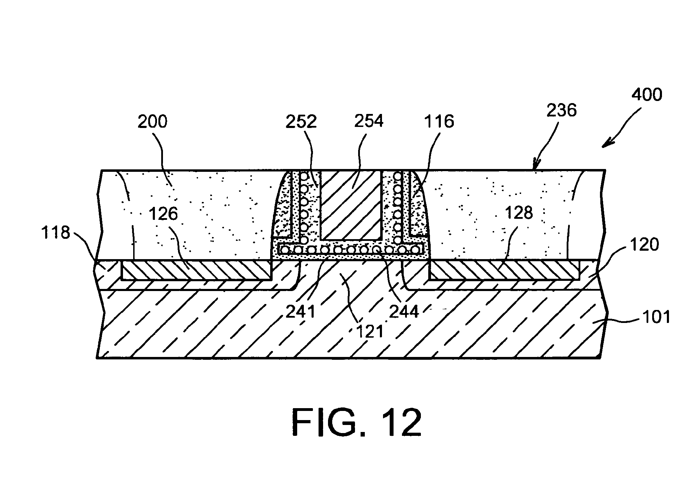

La figure 12 représente un dispositif mémoire 400 obtenu par la mise en oeuvre d'un procédé de réalisation de dispositif mémoire selon un troisième mode de réalisation.

Dans ce troisième mode de réalisation, on met en oeuvre les étapes précédemment décrites en liaison avec les figures 1 à 6.

Après avoir réalisé une gravure des premières portions 114 des espaceurs latéraux, le premier diélectrique 241 est obtenu par dépôt sur toutes les parois du trou 240, y compris dans les creux se trouvant sous les secondes portions 116 des espaceurs.

Le dispositif 400 est ensuite achevé de manière analogue au premier mode de réalisation, c'est-à-dire en étalant sur l'ensemble de la structure précédemment réalisée, par exemple par la mise en oeuvre d'un dépôt par centrifugation ou par pulvérisation, le liquide ionique 242 dans lequel des nanoparticules métalliques ont été synthétisées. Le liquide ionique s'étale également dans le creux précédemment formés sous les secondes portions 116 des espaceurs latéraux, contre le premier diélectrique 241.

On réalise alors l'incubation de l'ensemble afin de former un dépôt de nanoparticules contre le premier diélectrique 241. Le second diélectrique 252 et la grille de commande 254 sont ensuite réalisés de manière analogue au premier mode de réalisation.

## Revendications

1. Procédé de réalisation d'un dispositif mémoire (100, 300, 400) à nanoparticules (244), comportant au moins les étapes de :
a) réalisation, dans un substrat (101) à base d'au moins un semi-conducteur, de régions (118, 120) de source et de drain, et d'au moins un premier diélectrique (241) sur au moins une zone du substrat (101) disposée entre les régions (118, 120) de source et de drain et destinée à former un canal (121) du dispositif mémoire (100, 300, 400),
b) dépôt d'au moins un liquide (242), comprenant des nanoparticules d'au moins un matériau électriquement conducteur en suspension, recouvrant au moins ledit premier diélectrique (241),
c) formation d'un dépôt desdites nanoparticules (244) au moins sur ledit premier diélectrique (241),
d) retrait du liquide restant (242),
e) réalisation d'au moins un second diélectrique (252) et d'au moins une grille de commande (254) sur au moins une partie du dépôt de nanoparticles (244),
**caractérisé en ce que** le liquide est un liquide ionique.

2. Procédé selon la revendication 1, dans lequel la réalisation des régions (118, 120) de source et de drain au cours de l'étape a) est obtenue par la mise en oeuvre des étapes suivantes :
a1) réalisation d'au moins une grille factice (112) sur le substrat (101), au niveau de
ladite zone destinée à former le canal (121) du dispositif mémoire (100, 300, 400),
a2) implantation de dopants dans le substrat (101) en utilisant la grille factice (112) comme masque d'implantation, les zones dopées du substrat (101) obtenues formant les régions (118, 120) de source et de drain,
la grille factice (112) étant ensuite retirée avant la mise en oeuvre de l'étape b).

3. Procédé selon la revendication 2, comportant en outre, entre l'étape a2) et l'étape de retrait de la grille factice (112), les étapes suivantes :
- réalisation d'espaceurs (114, 116) à base d'au moins un matériau diélectrique contre les flancs latéraux de la grille factice (112),
- dépôt d'au moins une couche d'enrobage (200) sur la grille factice (112), les espaceurs (114, 116) et les régions (118, 120) de source et de drain,
- planarisation de la couche d'enrobage (200) avec arrêt sur la grille factice (112).

4. Procédé selon la revendication 3, comportant en outre, entre l'étape de retrait de la grille factice (112) et l'étape b) de dépôt du liquide ionique (242), une étape de gravure d'au moins une partie (114) des espaceurs (114, 116) en contact avec le substrat (101), formant des creux sous une partie restante (116) des espaceurs (242), le liquide ionique (242) étant également déposé, au cours de l'étape b), dans lesdits creux, et les nanoparticules (244) étant également déposées, au cours de l'étape c), au niveau de zones du substrat (101) situées dans lesdits creux.

5. Procédé selon l'une des revendications 3 ou 4, comportant en outre, entre l'étape de réalisation des espaceurs (114, 116) et l'étape de dépôt de la couche d'enrobage (200), une étape de siliciuration (126, 128) d'au moins une partie des régions (118, 120) de source et de drain.

6. Procédé selon l'une des revendications précédentes, dans lequel l'étape c) de formation du dépôt de nanoparticules (244) comporte au moins une étape d'incubation du substrat (101) et du liquide ionique (242) pendant une durée comprise entre environ cinq minutes et une heure.

7. Procédé selon l'une des revendications précédentes, dans lequel une différence de potentiels électriques non nulle est appliquée entre le substrat (101) et le liquide ionique (242) au cours d'au moins une partie de l'étape c) de formation du dépôt de nanoparticules (244).

8. Procédé selon la revendication 7, dans lequel la différence de potentiels électriques est appliquée, via le substrat (101), entre la région de source (118) et/ou de drain (120) et le liquide ionique (242).

9. Procédé selon l'une des revendications précédentes, dans lequel l'étape d) de retrait du liquide ionique (242) comporte une étape de rinçage par un solvant et une étape de séchage, ou une étape de dégradation par un traitement thermique à une température comprise entre environ 200°C et 500°C.

10. Procédé selon l'une des revendications précédentes, dans lequel l'étape e) de réalisation du second diélectrique (252) et de la grille de commande (254) est obtenue par la mise en oeuvre des étapes suivantes :
e1) dépôt d'une couche (246) à base d'un matériau diélectrique au moins sur le dépôt de nanoparticules (244),
e2) dépôt d'une couche (248) à base d'un matériau électriquement conducteur sur la couche (246) à base du matériau diélectrique,
e3) planarisation d'au moins ladite couche (248) à base du matériau électriquement conducteur et de ladite couche (246) à base du matériau diélectrique.

11. Procédé selon l'une des revendications précédentes, dans lequel le liquide ionique (242) comporte au moins un cation de type imidazolium porteur de substituants alkyles.

12. Procédé selon l'une des revendications précédentes, dans lequel le liquide ionique (242) est choisi parmi du BMIMNTf₂, du HMIMNTf₂ ou du OMIMNTf₂, et/ou les nanoparticules en suspension dans le liquide ionique (242) sont à base de ruthénium.

13. Procédé selon l'une des revendications précédentes, dans lequel le liquide ionique (242) est déposé par centrifugation ou par projection.

## Claims

1. Method for producing a memory device (100, 300, 400) with nanoparticles (244), comprising at least the steps of:
a) forming, in a substrate (101) comprising at least one semi-conductor, source and drain regions (118, 120), and at least one first dielectric (241) on at least one zone of the substrate (101) arranged between the source and drain regions (118, 120) and intended to form a channel (121) of the memory device (100, 300, 400),
b) deposition of at least one liquid (242), comprising nanoparticles of at least one electrically conductive material in suspension, covering at least said first dielectric (241),
c) formation of a deposition of said nanoparticles (244) at least on said first dielectric (241),
d) removal of the remaining liquid (242),
e) forming at least one second dielectric (252) and at least one control gate (254) on at least one part of the deposition of nanoparticles (244), **characterized in that** the liquid is a ionic liquid.

2. Method according to claim 1, wherein the formation of source and drain regions (118, 120) during step a) is obtained by the implementation of the following steps:
a1) forming at least one dummy gate (112) on the substrate (101), at the level of said zone intended to form the channel (121) of the memory device (100, 300, 400),
a2) implantation of dopants in the substrate (101) using the dummy gate (112) as implantation mask, the doped zones of the substrate (101) obtained forming the source and drain regions (118, 120),
the dummy gate (112) then being removed before the implementation of step b).

3. Method according to claim 2, further comprising, between step a2) and the step of removal of the dummy gate (112), the following steps:
- forming spacers (114, 116) comprising at least one dielectric material against the lateral flanks of the dummy gate (112),
- deposition of at least one coating layer (200) on the dummy gate (112), the spacers (114, 116) and the source and drain regions (118, 120),
- planarisation of the coating layer (200) with stop on the dummy gate (112).

4. Method according to claim 3, further comprising, between the step of removal of the dummy gate (112) and the step b) of depositing the ionic liquid (242), a step of etching at least one part (114) of the spacers (114, 116) in contact with the substrate (101), forming hollows underneath a remaining part (116) of the spacers (242), the ionic liquid (242) also being deposited, during step b), in said hollows, and the nanoparticles (244) also being deposited, during step c), at the level of zones of the substrate (101) situated in said hollows.

5. Method according to one of claims 3 or 4, further comprising, between the step of forming spacers (114, 116) and the step of depositing the coating layer (200), a step of silicidation (126, 128) of at least one part of the source and drain regions (118, 120).

6. Method according to one of the preceding claims, wherein the step c) of formation of the deposition of nanoparticles (244) comprises at least one step of incubation of the substrate (101) and of the ionic liquid (242) for a time lasting between around five minutes and one hour.

7. Method according to one of the preceding claims, wherein a non-zero difference of electric potentials is applied between the substrate (101) and the ionic liquid (242) during at least one part of step c) of formation of the deposition of nanoparticles (244).

8. Method according to claim 7, wherein the difference of electric potentials is applied, via the substrate (101), between the source (118) and/or drain (120) region and the ionic liquid (242).

9. Method according to one of the preceding claims, wherein the step d) of removal of the ionic liquid (242) comprises a step of rinsing by a solvent and a step of drying, or a step of degradation by a heat treatment at a temperature between around 200°C and 500°C.

10. Method according to one of the preceding claims, wherein step e) of forming the second dielectric (252) and the control gate (254) is obtained by the implementation of the following steps:
e1) deposition of a layer (246) comprising a dielectric material at least on the deposition of nanoparticles (244),
e2) deposition of a layer (248) comprising an electrically conductive material on the layer (246) comprising the dielectric material,
e3) planarisation of at least said layer (248) comprising the electrically conductive material and said layer (246) comprising the dielectric material.

11. Method according to one of the preceding claims, wherein the ionic liquid (242) comprises at least one cation of alkyl substituent bearing imidazolium type.

12. Method according to one of the preceding claims, wherein the ionic liquid (242) is chosen among BMIMNTf₂, HMIMNTf₂ or OMIMNTf₂, and/or the nanoparticles in suspension in the ionic liquid (242) comprising ruthenium.

13. Method according to one of the preceding claims, wherein the ionic liquid (242) is deposited by spin coating or by spraying.

## Patentansprüche

1. Verfahren zur Herstellung einer Speichervorrichtung (100, 300, 400) mit Nanopartikeln (244), das Verfahren umfassend die folgenden Verfahrensschritte bzw. -stufen :
a) in einem Substrat (101) auf Basis wenigstens eines Halbleiters werden Source- und Drainbereiche (118, 120) ausgebildet sowie wenigstens ein erstes Dielektrikum (241) auf wenigstens einer zwischen den Source - und Drainbereichen (118, 120) gelegenen Zone des Substrats (101), die zur Bildung eines Kanals (121) der Speichervorrichtung (100, 300, 400) bestimmt ist,
b) Abscheiden wenigstens einer Flüssigkeit (242), welche Nanopartikel wenigstens eines elektrisch leitenden Materials in Suspension aufweist und wenigstens das genannte erste Dielektrikum (241) überdeckt,
c) Ausbilden einer Abscheidung der genannten Nanopartikel (244) auf wenigstens dem genannten ersten Dielektrikum (241),
d) Abziehen bzw. Entfernen der verbliebenen Flüssigkeit (242),
e) Herstellen wenigstens eines zweiten Dielektrikums (252) und wenigstens eines Steuer-Gate (254) auf wenigstens einem Teil der Abscheidung von Nanopartikeln (244),
**dadurch gekennzeichnet dass** die Flüssigkeit eine ionische Flüssigkeit (Ionenflüssigkeit) ist.

2. Verfahren nach Anspruch 1, bei welchem die Herstellung der Source- und Drainbereiche (118, 120) im Verlauf der Verfahrensstufe a) mittels Anwendung bzw. Ausführung der folgenden Verfahrensschritte bzw. -stufen erfolgt:
a1) Ausbilden wenigstens eines faktischen bzw. pro-forma Gate (112) auf dem Substrat (101), auf dem Niveau der genannten zur Bildung des Kanals (121) der Speichervorrichtung (100, 300, 400) bestimmten Zone,
a2) Implantation von Dotierungssubstanzen in das Substrat (101) unter Verwendung des faktischen Gates (112) als Implantationsmaske, wobei die hierbei erhaltenen dotierten Zonen des Substrats (101) die Source- und Drainbereiche (118, 120) bilden,
wobei das faktische Gate (112) sodann vor der Ausführung der Verfahrensstufe b) entfernt wird.

3. Verfahren nach Anspruch 2, welches des Weiteren zwischen der Verfahrensstufe a2) und der Verfahrensstufe der Entfernung des faktischen Gates (112) die folgenden Schritte bzw. Stufen umfasst:
-- Ausbilden von Abstandshaltern (114, 116) auf Basis wenigstens eines dielektrischen Materials, an den Seitenflanken des faktischen Gates (112),
-- Abscheiden wenigstens einer Umhüllungs- bzw. Ummantelungsschicht (200) auf dem faktischen Gate (112), den Abstandshaltern (114, 116) sowie den Source- und Drainbereichen (118, 120),
-- Planierungsabtragung der Umhüllungs- bzw. Ummantelungsschicht (200) mit Stop der Abtragung auf dem faktischen Gate (112).

4. Verfahren nach Anspruch 3, welches des Weiteren zwischen der Verfahrensstufe der Entfernung des faktischen Gate (112) und der Verfahrensstufe b) der Abscheidung der ionischen Flüssigkeit (242)(loinenflüssigkeit) eine Verfahrensstufe der Ätzung wenigstens eines mit dem Substrat (101) in Kontaktberührung stehenden Teils derAbstandshalter (114, 116) umfasst, unter Bildung von Hohlräumen bzw. Ausnehmungen unter einem verbleibenden Teil (116) der Abstandshalter (242), wobei die Ionenflüssigkeit (242) im Verlauf der Stufe b) gleichzeitig auch in diesen Hohlräumen abgeschieden wird und die Nanopartikel (244) ebenfalls während der Verfahrensstufe b) auf dem Niveau von in diesen Hohlräumen gelegenen Zonen des Substrats (101) abgeschieden werden.

5. Verfahren nach einem der Ansprüche 3 oder 4, welches des Weiteren zwischen der Stufe der Herstellung der Abstandshalter (114, 116) und der Stufe der Abscheidung der Umhüllungs- bzw. Ummantelungsschicht (200) eine Verfahrensstufe bzw. einen Verfahrensschritt der Silizidierung (126, 128) wenigstens eines Teils der Source- und Drainbereiche (118, 120) umfasst.

6. Verfahren nach einem der vorhergehenden Ansprüche, bei welchem der Verfahrensschritt bzw. die Verfahrensstufe c) der Bildung der Abscheidung von Nanopartikeln (244) wenigstens eine Stufe bzw. einen Schritt einer Inkubation bzw. Wärmebehandlung des Substrats (101) und der Ionenflüssigkeit (242) während einer Dauer im Bereich zwischen etwa 5 Minuten und einer Stunde umfasst.

7. Verfahren nach einem der vorhergehenden Ansprüche, bei welchem eine von Null verschiedene Differenz elektrischer Potentiale zwischen dem Substrat (101) und der Ionenflüssigkeit (242) im Verlauf wenigstens eines Teils der Stufe bzw. des Schritts c) der Bildung der Abscheidung von Nanopartikeln (244) angelegt wird.

8. Verfahren nach Anspruch 7, bei welchem die Differenz elektrischer Potentiale über das Substrat (101) zwischen dem Sourcebereich (118) und/oder dem Drainbereich (120) und der Ionenflüssigkeit (242) angelegt wird.

9. Verfahren nach einem der vorhergehenden Ansprüche, bei welchem der Verfahrensschritt bzw. die Verfahrensstufe d) der Entfernung der Ionenflüssigkeit (242) eine Stufe der Spülung mit einem Lösungsmittel und eine Stufe der Trocknung oder eine Stufe der Degradation mittels einer Wärmebehandlung bei einer Temperatur im Bereich zwischen ca. 200° C und 500° C umfasst.

10. Verfahren nach einem der vorhergehenden Ansprüche, bei welchem die Verfahrensstufe e) der Erzeugung des zweiten Dielektrikums (252) und des Steuer-Gate (254) durch Ausführung der folgenden Stufen erfolgt:
e1) Abscheiden einer Schicht (246) auf Basis eines dielektrischen Materials auf wenigstens der Abscheidung von Nanopartikeln (244),
e2) Abscheiden einer Schicht (248) auf Basis eines elektrisch leitenden Materials auf der Schicht (246) auf Basis des dielektrischen Materials,
e3) Planierung wenigstens der genannten Schicht (248) auf Basis des elektrischen Leitermaterials, und der genannten Schicht (246) auf Basis des dielektrischen Materials.

11. Verfahren nach einem der vorhergehenden Ansprüche, bei welchem die Ionenflüssigkeit (242) wenigstens ein Kation vom Imidazolium-Typ als Träger von Alkylsubstituenten aufweist.

12. Verfahren nach einem der vorhergehenden Ansprüche, bei welchem die Ionenflüssigkeit (242) unter BMIMNTf₂, HMIMNTf₂, oder OMINNTf₂ gewählt wird und/oder bei welchem die in der Ionenflüssigkeit (242) suspendierten Nanopartikel Teilchen auf Rutheniumbasis sind.

13. Verfahren nach einem der vorhergehenden Ansprüche, bei welchem die ionische Flüssigkeit (Ionenflüssigkeit) (242) mittels Zentrifugation oder mittels Projektions- bzw. Schleuderverfahren abgeschieden wird.
